(19) **Europäisches Patentamt**

**European Patent Office**

**Office européen des brevets**

(11) **EP 1 732 309 A1**

(12) **EUROPÄISCHE PATENTANMELDUNG**

(43) Veröffentlichungstag:
**13.12.2006 Patentblatt 2006/50**

(51) Int Cl.:
**H04N 5/12** *(2006.01)*

(21) Anmeldenummer: **06011435.2**

(22) Anmeldetag: **02.06.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **02.06.2005 DE 102005025453**

(71) Anmelder: **Micronas Holding GmbH**
**79108 Freiburg (DE)**

(72) Erfinder:
- **Bauer, Achim**
  **9500 Villach (AT)**

- **Gaier, Ulrich**
  **9500 Villach (AT)**
- **Lehmacher, Frank**
  **9500 Villach (AT)**
- **Waldner, Markus**
  **9020 Klagenfurt (AT)**

(74) Vertreter: **Göhring, Robert**
**Patentanwälte**
**Westphal, Mussgnug**
**Am Riettor 5**
**78048 Villingen-Schwenningen (DE)**

(54) **Vorrichtung zur Ermittlung eines Maßes für eine Signaländerung und Verfahren zur Phasenregelung**

(57)    Die Erfindung bezieht sich auf ein Verfahren zur Gradientenermittlung, bei dem eine Änderung eines Signalpegels eines Eingangssignals (sigp, sign) zwischen zwei Zeitpunkten bestimmt und mit Referenzwerten (refl, refh) verglichen wird, wobei abhängig vom Vergleich ein Maß für den Gradienten des Eingangssignals ermittelt wird. Außerdem bezieht sich die Erfindung auf eine Vorrichtung zur Gradientenermittlung, die dazu ausgebildet ist, die Änderung eines Signalpegels eines Eingangssignals (sigp, sign) zwischen zwei Zeitpunkten mit Referenzwerten zu vergleichen und abhängig von dem Vergleich ein Maß für den Signalgradienten zu ermitteln.

EP 1 732 309 A1

**Beschreibung**

Die Erfindung betrifft eine Vorrichtung zur Ermittlung eines Maßes für eine Signaländerung gemäß den oberbegrifflichen Merkmalen des Patentanspruchs 9 und ein Verfahren gemäß den oberbegrifflichen Merkmalen des Patentanspruchs 1, insbesondere zur Phasenregelung unter Verwendung einer solchen Schaltung.

Stand der Technik

Bisher wird eine Gradientendetektion bei einer Phasenregelung mit kontinuierlichen Messschaltungen durchgeführt, etwa mit einem Operationsverstärker, der als Differenzierer beschaltet wird. Hinter den Differenzierer wird ggf. eine Verstärkungsanpassung vorgenommen und abschließend folgt ein AD-Wandler (AD: Analog/Digital), der die Gradienteninformation zu einem bestimmten Zeitpunkt digitalisiert.

Der Signalpfad wird dabei allerdings kontinuierlich durch einen frequenzabhängigen Stromfluss belastet. Außerdem verteuert sich ein Chip zum Durchführen eines solchen Verfahrens ggf. aufgrund eines erhöhten Flächen- und Leistungsbedarfs. Der Phasengang einer entsprechenden Sensorschaltung muss bekannt sein und bei der Phasenregelung entsprechend berücksichtigt werden.

Die Phasenregelung erfolgt typischerweise durch:

Gemäß einer ersten Verfahrensweise wird ein mehrfaches Abtasten pro Pixelperiode durchgeführt. Nachteilig ist hierbei, dass insbesondere bei schnellen Abtastraten im Signalpfad eine weitere Erhöhung der Abtastrate zu einer wesentlichen Verminderung der Auflösung der AD-Wandler führen und deren Leistungsverbrauch übermäßig steigern kann.

Gemäß einer zweiten Verfahrensweise wird ein Senden eines zusätzlichen Referenzsignals mit bekanntem Verlauf bzw. einer bekannten Pixelfrequenz durchgeführt. Ein zusätzliches Referenzsignal mit bekanntem Verlauf bzw. bekannter Pixelfrequenz steht für viele Anwendungen allerdings nicht zur Verfügung und bedeutet ggf. einen erheblichen technischen Zusatzaufwand.

Gemäß einer dritten Verfahrensweise wird eine Phasenregelung unter Anwendung statistischer Verfahren durchgeführt, z.B. durch Maximierung eines durchschnittlichen Differenzbetrages zweier aufeinanderfolgender Abtastwerte. Hierbei können große Latenzzeiten auftreten, die insbesondere bei bewegten Bildern kritisch sind. Außerdem kann eine Phasendrift ggf. nicht mehr schnell genug ausgeregelt werden.

Gemäß einer vierten Verfahrensweise wird gemäß der nachveröffentlichten DE 10 2004 027 093 ein Verfahren beschrieben, bei dem digitalisierte Gradienten- und Abtastwerte benutzt werden, um die Phasenlage eines eingeschwungenen Signalabschnittes abzuschätzen. Bei diesem Vorgehen ist die Güte des Regelalgorithmus abhängig von der Signalform. Weicht diese Signalform stark von der Sinusform ab, arbeitet der Regelalgorithmus unter Umständen nicht mehr effizient.

Die Aufgabe der Erfindung besteht darin, eine Vorrichtung zur Ermittlung eines Maßes für eine Signaländerung und ein Verfahren zur Phasenregelung unter Verwendung einer solchen Schaltung zu verbessern.

Diese Aufgabe wird gelöst durch ein Verfahren zur Gradientenermittlung gemäß den Merkmalen des Patentanspruchs 1 bzw. durch eine Vorrichtung zur Ermittlung eines Maßes für eine Signaländerung gemäß den Merkmalen des Patentanspruchs 9. Vorteilhafte Ausgestaltungen sind Gegenstand abhängiger Ansprüche.

Bevorzugt wird ein Verfahren zur Gradientenermittlung, bei dem eine Änderung eines Signalpegels eines Eingangssignals zwischen zwei Zeitpunkten bestimmt und mit Referenzwerten verglichen wird, wobei abhängig vom Vergleich ein Maß für den Gradienten des Eingangssignals ermittelt wird.

Insbesondere bevorzugt wird ein Verfahren bei dem eine Phase eines Taktes für eine Signalverarbeitung relativ zu einem Messtakt eingestellt wird. Vorteilhaft ist ein Verfahren bei dem aus einer unmittelbaren zeitlichen Abfolge mehrerer Gradienten ein Maß für den Gradientenverlauf und/oder eine Krümmung des Eingangssignals ermittelt wird. Weiter bevorzugt wird ein Verfahren bei dem aus einer sequenziellen Auswertung von Werten der Krümmung eine Richtung der Phasendrift des Eingangssignals bestimmt und zur Regelung einer Phase eines Taktes für eine Signalverarbeitung verwendet wird. Vorteilhaft ist das beschriebene Verfahren insbesondere dann, wenn eine exakte Anzahl von Signalperioden zwischen zwei Synchronisationssignalen nicht bekannt ist und/oder eine Übertragungsrate zeitlich schwankt. Weiter bevorzugt wird ein Verfahren bei dem Signalverläufe auf Basis von Werten des ermittelten Gradienten des Eingangssignals geregelt werden.

Bevorzugt wird demgemäß eine Vorrichtung zur Gradientenermittlung, die dazu ausgebildet ist, die Änderung eines Signalpegels eines Eingangssignals zwischen zwei Zeitpunkten mit Referenzwerten zu vergleichen und abhängig von dem Vergleich ein Maß für den Signalgradienten zu ermitteln.

Bevorzugt wird insbesondere eine solche Vorrichtung mit einer sample&track-Stufe und einer dieser nachgeschalteten Vergleichsschaltung zum Vergleichen der Änderung des Signalpegels mit den Referenzwerten. Weiter bevorzugt wird eine Vorrichtung mit einer sample&hold-Stufe und einer dieser nachgeschalteten Vergleichsschaltung zum Vergleichen der Änderung des Signalpegels mit den Referenzwerten. Außerdem vorteilhaft ist eine Vorrichtung mit einer Stufe zur differenziellen und/oder Single-Ended-Gradientenmessung. Vorzugsweise ist eine derartige Vorrichtung zum Ausführen eines solchen Verfahrens entsprechend ausgebildet.

Gemäß einem Kerngedanken der Erfindung sind in vielen technischen Applikationen Signalfolgen mit einem zeit- und wertdiskreten Verlauf in einer Empfängerschaltung zu verarbeiten. Dabei können sich folgende Problemstellungen ergeben, welche durch eine Gradientendetektion bei einer Phasenregelung in zeitdiskreter Weise vermieden werden.

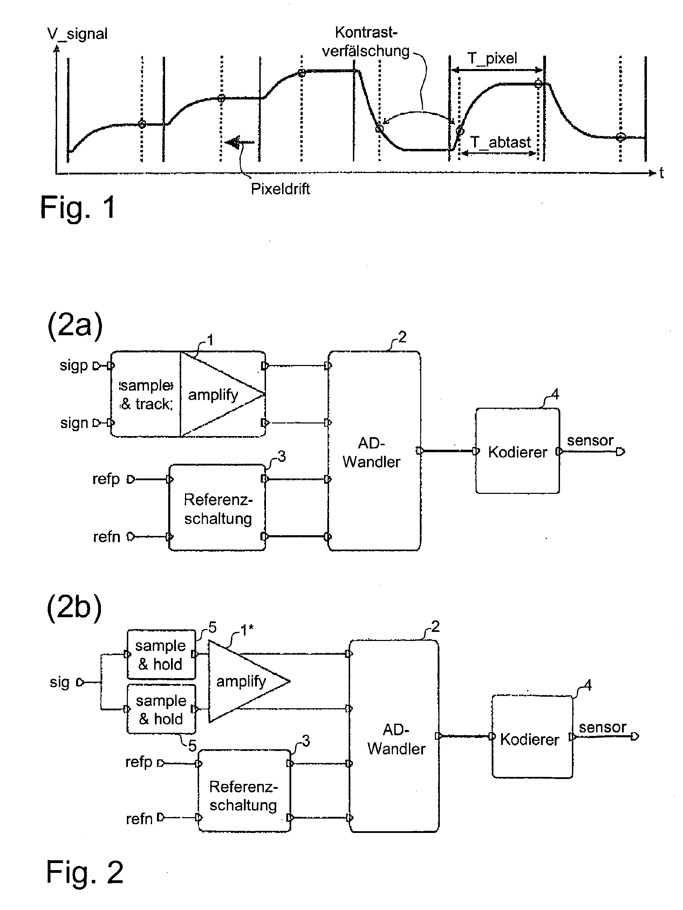

Ist eine hinreichend genaue Taktrekonstruktion bezüglich der empfangenen Signalsequenz etwa mittels Synchronisationssignalen erfolgt, so sollte bei der Signalverarbeitung z.B. für eine AD-Wandlung sichergestellt sein, dass diese nicht während der Übergangsphase zwischen zwei wertdiskreten Signalzuständen stattfindet, wie dies der zeit- und wertdiskreten Bildpunktabfolge mit Phasendrift zum Abtasttakt aus Fig. 1 ersichtlich ist, da hierdurch die Signalkontraste stark vermindert werden können. Die bevorzugten Schaltungen vergleichen die insbesondere verstärkte Änderung des Signalpegels zwischen zwei Zeitpunkten mit Referenzwerten und ermitteln daraus ein grobes Maß für den jeweiligen Signalgradienten, so dass die Phase des Taktes für die Signalverarbeitung relativ zum Messtakt eingestellt werden kann.

Fig. 1 zeigt dabei eine Signalspannung V_signal über die Zeit t. Abtastzeitpunkte T_pixel für Bildpunkte sind hinsichtlich der Zeitdauer bzw. Periode unterschiedlich zu tatsächlichen Abtastzeitpunkten T_abtast, was bei nicht ausreichender Phasenregelung zu einer Kontrastverfälschung führt.

Falls die Taktrekonstruktion nicht mit der erforderlichen Genauigkeit möglich ist, da die exakte Anzahl der Signalperioden zwischen zwei Synchronisationssignalen nicht bekannt ist oder weil die Übertragungsrate mit der Zeit schwankt, kann aus der unmittelbaren zeitlichen Abfolge mehrerer Gradienten vorzugsweise ein grobes Maß für die Krümmung des Signals ermittelt werden. Aus der sequentiellen Auswertung der Krümmungswerte kann die Richtung der Phasendrift des Signals bestimmt und zur Regelung herangezogen werden, wie dies aus Fig. 7 ersichtlich ist.

Der Signalverlauf soll dadurch rekonstruiert werden. D.h. aus abgetasteten Signal- und Gradientenwerten wird ein Maß für Signalwerte zwischen den Abtastpunkten ermittelt, wozu insbesondere eine Interpolation durchgeführt wird.

Die zuvor genannten Nachteile können durch die erfindungsgemä-βe Schaltung und das erfindungsgemäße Verfahren vermieden werden.

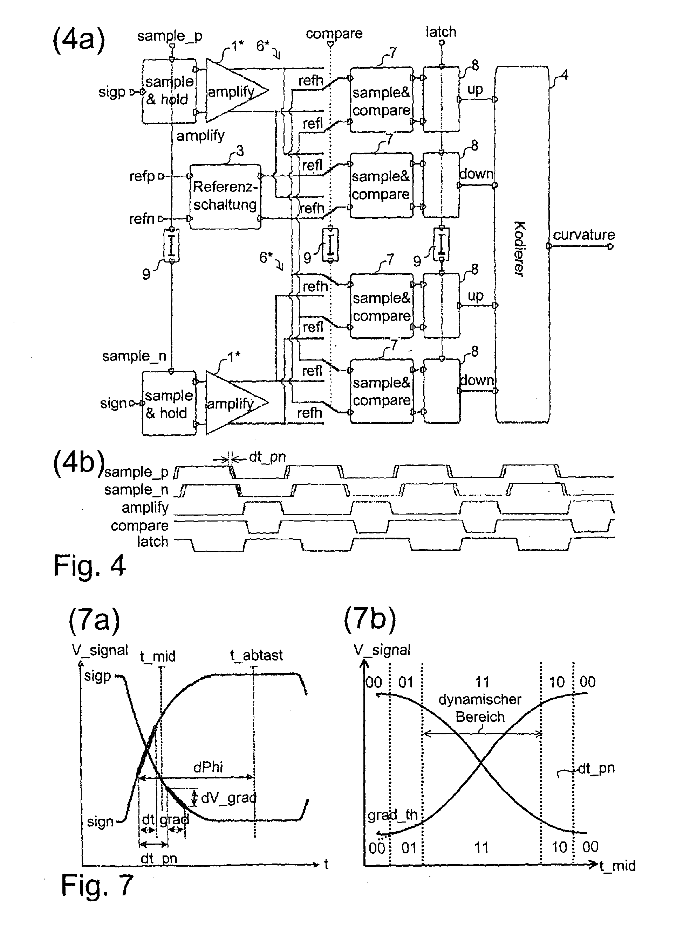

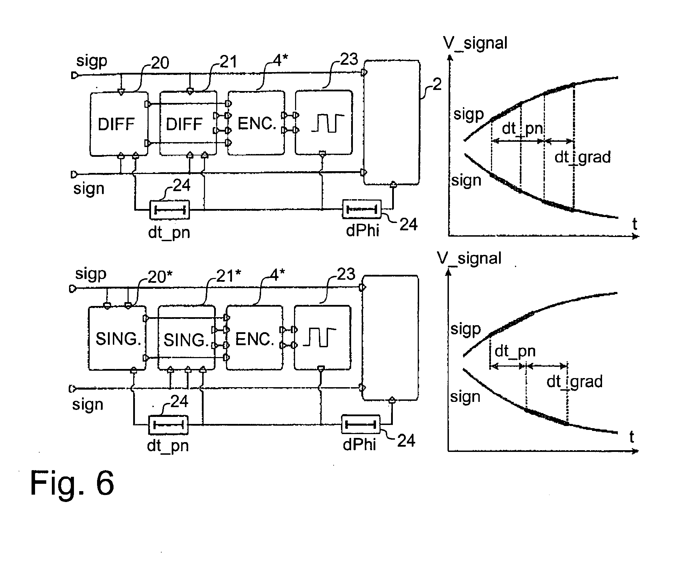

Die erfindungsgemäß bevorzugten Schaltungen eines allgemein besonders bevorzugten Konzepts für die Gradientendetektion belasten den Signalpfad lediglich mit einer moderaten kapazitiven Last, welche typ. unter 100F liegt. Um den Flächenbedarf zu minimieren, wird bei den erfindungsgemäßen Implementierungen die Auflösung des Gradienten auf wenige Bit beschränkt, beispielsweise auf ein Bit beschränkt, wie dies aus Fig. 4 ersichtlich ist. Diese Abstraktion der Steigung stellt allerdings in vielen Applikationen keine wesentliche Einschränkung für die Funktion der Regelalgorithmen dar. Der Vergleich mit den Referenzspannungen kann ebenfalls platzsparend mittels einer Inverterstruktur realisiert werden, wie dies aus Fig. 5 ersichtlich ist. Dadurch sind die angegebenen Schaltungen sehr kompakt.

Wird das Signal in der Applikation beispielsweise direkt vor einem AD-Wandler vermessen, so ist der Phasenbezug zwischen detektiertem Gradienten und abgetasteten Signalwert in guter Näherung durch den Phasenunterschied der jeweiligen digitalen Steuersignale gegeben, die Phasenverschiebung entlang des Messpfades kann typischerweise vernachlässigt werden.

Folgende Vorteile besitzt das erfindungsgemäße Verfahren bezüglich der Phasenregelung:

Erstens ist eine Erhöhung der Abtastrate im Signalpfad ist nicht mehr nötig. Anhand der Lage der maximalen Gradienten bzw. der Änderung des Gradientenverlaufs kann der optimale Abtastzeitpunkt präzise eingestellt werden.

Zweitens ist ein zusätzliches Referenzsignal nicht erforderlich. Es genügen die üblichen Synchronpulse und die Angabe der Frequenz der übertragenen Signalpixel mit einer hinreichenden Genauigkeit. Die größte tolerierbare Frequenzabweichung hängt von der Feinheit der Phaseneinstellung bzw. ggf. vom Verhältnis aus PLL-Frequenz (PLL: Phase Locked Loop / phasengeregelte Schleife) und der Pixelfrequenz sowie von der Grenzfrequenz des Signalpfades und den Kontrasten im Signal ab.

Drittens können große Latenzzeiten vermieden werden. Ein einziger Sensorwert kann bereits zur Phasenkorrektur herangezogen werden. Damit wird eine Phasenregelung "in Echtzeit" bzw. nahezu in Echtzeit ermöglicht.

Viertens ist die Regelgüte weitgehend unabhängig von der Signalform. Weist der Signalverlauf einerseits einen gewissen Mindestwert bei den Gradienten in der Übergangsphase auf und gibt es andererseits eingeschwungene Signalabschnitte, in denen der Gradient unter diesem Mindestwert liegt, so ist eine optimale Phasenregelung möglich.

Genaue Beschreibung der Erfindung

Ein Ausführungsbeispiel der Erfindung wird nachfolgend anhand der Zeichnung näher erläutert. Es zeigen:

Fig. 1:    eine zeit- und wertdiskrete Pixelfolge mit Phasendrift zum Abtasttakt,

Fig. 2:    Prinzipschaltbilder für die Gradientenmessung mit Abtasten und Nachverfolgen (engl. sample & track) (a) bzw. Abtasten und Halten (engl. sample & hold) (b),

Fig. 3:    eine Schaltung für 1,5 Bit der sample & trackTopologie bei differentieller Messung (a) und typische Signale (b),

Fig. 4:    eine Schaltung für 1,5 Bit der sample & hold-Topologie bei zwei single-ended Messungen (a) und typische Signale (b),

Fig. 5:    eine kompakte Ausführung der sample & hold-Topologie,

Fig. 6:    verschiedene Sensoranordnungen und

Fig. 7:    eine Gradientenmessung und Sensorwerte in Abhängigkeit von der Phase.

Im Folgenden werden zwei Sensorschaltungen für die Gradientenmessung angegeben, die sich wesentlich in der Art der Messwerterfassung unterscheiden.

Die in Fig. 2a dargestellte Variante einer solchen Sensorschaltung besitzt als Eingangsstufe zur Erfassung des Gradienten einen Verstärker 1, der im sample&track-Verfahren arbeitet. Eine dem Verstärker 1 vorgeschalteten oder in dessen Eingangsbereich integrierten sampel&track-Stufe bekommt in für sich bekannter Art und Weise zwei Eingangssignale sigp, sign angelegt. Zwei vom Verstärker 1 bzw. der Verstärkerschaltung ausgegebene Signale werden einem AD-Wandler 2 angelegt. Eine Referenzschaltung 3 erhält zwei Referenzsignale refp, refn angelegt, wobei zwei Ausgänge der Referenzschaltung ebenfalls an Eingängen des AD-Wandlers 2 angelegt sind. Ein Ausgang des AD-Wandlers 2 zum Ausgeben eines digitalen Signals bzw. Datenstroms ist einem Kodierer 4 angelegt, dessen Ausgangssignal einem Sensorsignal "sensor" entspricht.

Die Variante in Fig. 2b erfasst den Gradienten dagegen single-ended über zwei sample&hold-Stufen 5, die zeitlich versetzt angesteuert werden. Der abgetastete und verstärkte Gradient wird prinzipiell in beiden Fällen in einem AD-Wandler 2 ADgewandelt. Das Wandlerergebnis kann anschließend in einem Kodierer 4 noch geeignet kodiert werden. Die Schaltungsanordnung gemäß Fig. 2b unterscheidet sich somit von der Schaltungsanordnung gemäß Fig. 2a dadurch, dass gemäß Fig. 2b einem Verstärker 1* die sample&hold-Stufen 5 an dessen Eingängen vorgeschaltet sind, wobei den beiden sample&hold-Stufen 5 ein gemeinsames Eingangssignal sig angelegt wird.

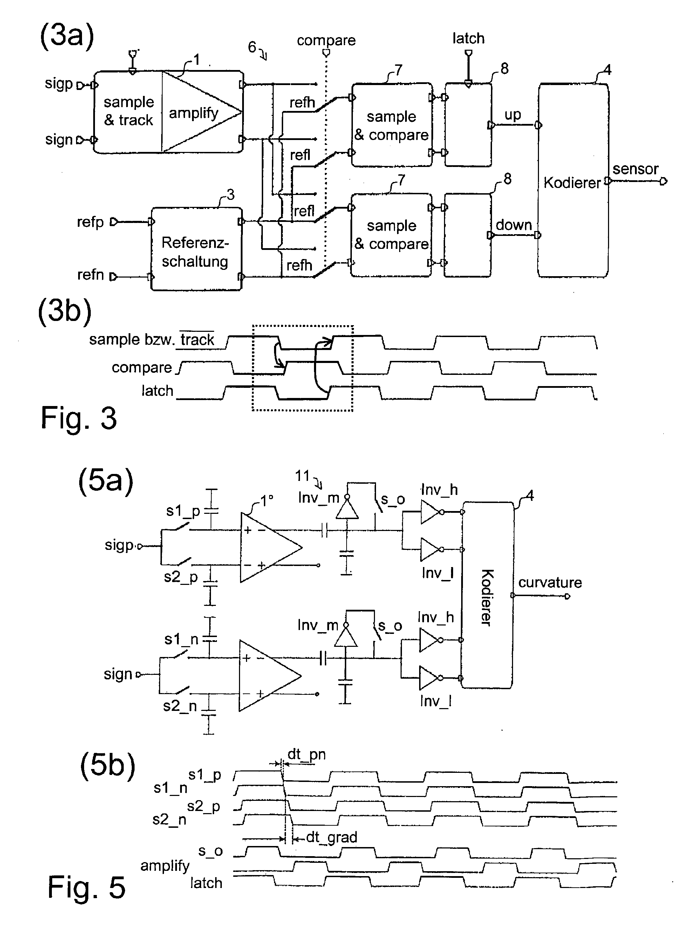

Fig. 3 zeigt eine Schaltung für 1,5 Bit der sample & track-Topologie bei differentieller Messung (a) und typische Signale (b) einer solchen Schaltung.

Die erste Schaltungsvariante und vergleichbar auch die Schaltung in Fig. 3a in 1,5bit Ausführung erfasst in der Sample-Phase das zu messende differentielle Signal und schaltet dann in den Track-Modus. In diesem Track-Modus bleibt der Anfangswert des differentiellen Signals gespeichert und die Änderung des Signals wird relativ zum gespeicherten Anfangspegel für eine gewisse und vorzugsweise einstellbare Zeit weiter verfolgt und verstärkt. Diese verstärkte Differenz zwischen gesampeltem und getracktem Signalwert wird ihrerseits wieder zu einem Abtastzeitpunkt erfasst und abhängig von der gewünschten Auflösung des Gradienten mit einer entsprechenden Anzahl von Referenzwerten refh, refl verglichen. Das Ergebnis dieses Vergleiches wird registriert und im Kodierer 4 je nach Applikation passend kodiert.

Einige typische Steuersignale für dieses Verfahren sind exemplarisch in Fig. 3a dargestellt. Wie auch bei den übrigen Fig. werden für in den jeweiligen Schaltungen gleiche oder gleich wirkende Komponenten und Funktionen jeweils gleiche oder gegebenenfalls mit einem * gekennzeichnete Bezugszeichen verwendet, wobei bezüglich der Beschreibung gegebenenfalls auf die jeweils übrigen Ausführungsformen der anderen Fig. verwiesen wird.

Zur Umsetzung entspricht die Schaltung gemäß Fig. 3a vom Grundgedanken her der Schaltung gemäß Fig. 2a. Gegenüber der Schaltung gemäß Fig. 2a ist jedoch an Stelle eines einheitlichen AD-Wandlers 2 eine aufwändigere Schaltungsanordnung dargestellt.

Aus dem Verstärker 1 bzw. der Verstärkerschaltung werden die Ausgangsleitungen einer Schaltungsanordnung 6 zugeführt. Außerdem werden die von der Referenzschaltung 3 ausgegebenen Referenzsignale refh, refl ebenfalls der Schaltungsanordnung 6 zugeführt. Jeweils zwei Eingänge von zwei sample&compare-Stufen 7 (sample&compare: abtasten und vergleichen) sind zum Durchführen eines Vergleichs mittels der Schaltungsanordnung 6 abhängig von einem Vergleichs-Schaltsignal compare wahlweise auf die beiden Ausgänge der Verstärkeranordnung mit dem Verstärker 1 oder auf die beiden Ausgänge der Referenzschaltung 3 schaltbar. Jeweils zwei Ausgänge der sample&compare-Stufen 7 sind jeweils einem Verzögerungsmodul 8 angelegt, wobei den Verzögerungsmodulen 8 ein Verzögerungssignal latch anlegbar ist. Von den beiden Verzögerungsmodulen 8 wird jeweils ein Signal up, down an zwei Eingänge eines Kodierers 4 angelegt. Fig. 3b zeigt Signalzustände des Abtastsignals sample bzw. des invertierten Nachführsignals track, sowie des Vergleichs-Schaltsignals compare und des Verzögerungssignals latch. Das Verzögerungssignal latch wirkt sich geringfuegig vor dem Abtastsignal sample aus. Das Abtastsignal sample wirkt sich wiederum geringfuegig vor dem Vergleichs-Schaltsignal compare aus.

Die nachfolgend verwendete Kodierung ist lediglich eine beispielhafte Angabe für eine 1,5 bit-Auflösung des Gradienten. Ist der verstärkte Differenzbetrag positiv und übersteigt einen positiven Referenzwert, so wird auf positiven Gradienten entschieden und eine erste Variable *sensor* = 01 gesetzt. Unterschreitet der verstärkte Differenzbetrag dagegen einen negativen Referenzwert, so wird auf negativen Gradienten entschieden und die erste Variable *sensor* = 10 gesetzt. Bleibt die verstärkte Differenz innerhalb der beiden Referenzwerte, so wird auf vernachlässigbaren Gradienten bzw. auf eingeschwungene Phase entschieden und die erste Variable *sensor* = 00 gesetzt. Die referenzabhängigen Schwellwerte werden so gewaehlt, dass sich Störeinflüsse wie Verstärker-Offset und unvollständiges Einschwingen nicht auf die Regelung auswirken.

Bei der zweiten Schaltungsvariante gemäß Fig. 2b und 4a handelt es sich um eine Sample&Hold-Architektur. Die beiden Messwerte zur Bestimmung des Gradienten werden jeweils zu zwei unterschiedlichen Zeitpunkten singleended erfasst und gehalten. Ein Zeitintervall *dt_grad* zwischen den beiden Messwerten ist vorzugsweise einstellbar. Die Differenz der beiden Messwerte *dV_grad* wird während der Halte- bzw. hold-Phase verstärkt (*amp*-Faktor), mit Referenzwerten refp, refh verglichen und anschließend je nach Verwendung kodiert.

Die angegebene Schaltung gemäß Fig. 4a ist für die Messung zweier aufeinanderfolgender Gradienten konzipiert. Fig. 4a baut dabei in vergleichbarer Art und Weise auf Fig. 2b auf, wie Fig. 3a auf Fig. 2a aufbaut. Bei Fig. 4a sind über eine Schaltungsanordnung 6* in vergleichbarer Art und Weise wie in Fig. 3a zwischen den Verstärker 1* und die Referenzschaltung 3 einerseits und andererseits den Kodierer 4 eine Schaltungsanordnung 6*, welche mit einem Vergleichs-Schaltsignal compare schaltbar ist, zwei sample&compare-Stufen 7 und zwei Verzögerungsmodule 8 geschaltet. Die Verzögerungsmodule 8 werden mittels eines vorzugsweise gemeinsamen Haltesignals bzw. Verzögerungssignals latch geschaltet. Der sample&hold-Sufe 5 (Bezeichner fehlt in Fig. 3a und 4a) wird als Eingangssignal ein erstes Eingangssignal sigp angelegt.

Parallel zu diese Anordnung von Komponenten ist eine weitere Anordnung mit gleichartig ausgebildeten Komponenten geschaltet, d. h. einer sample&hold-Stufe 5, einem weiteren Verstärker 1*, einer weiteren Schaltungsanordnung 6* oder einer entsprechend verlängerten Schaltungsanordnung 6*, zwei sample&compare-Stufen 7 und zwei Verzögerungsmodulen 8, deren Ausgangssignale up, down im Kodierer 4 an zwei weiteren Eingängen angelegt werden. Der Kodierer 4 gibt bei Verwendung einer solchen Schaltungsanordnung an seinem digitalen Ausgang Werte einer Krümmung curvature aus.

Ein Unterschied gemäß der oberen Hälfte der Schaltungsanordnung besteht darin, dass die unter Hälfte der Schaltungsanordnung keine eigene Referenzschaltung 3 aufweisen muss. Der unteren Hälfte der gemeinsamen Schaltungsanordnung 6* bzw. einer eigenen unteren Schaltungsanordnung 6* werden als Referenzsignale refh, refl die Ausgangswerte der Referenzschaltung 3 der oberen Hälfte der Schaltungsanordnung angelegt.

Das Verzögerungsmodul 9 soll den zeitlichen Versatz dt_pn zwischen den beiden Gradientenmessungen andeuten. Einige relevante Steuersignale für dieses Verfahren sind exemplarisch in Fig. 4b dargestellt. Dargestellt sind ein Abtastschaltsignal sample_p als Schaltsignal für die erste sample&hold-Stufe 5, welcher das erste Eingangssignal sigp angelegt wird und ein zweites Abtastschaltsignal sample_n, welches der zweiten sample&hold-Stufe 5 als Schaltsignal angelegt wird, wobei der zweiten sample&hold-Stufe 5 als Eingangssignal ein zweites Eingangssignal sign angelegt wird. Über entsprechende Koppelelemente 9 können die beiden Abtastschaltsignale sample_p, sample_n sowie auch entsprechend das Vergleichssignal compare und das Verzögerungs- bzw. Haltesignal latch von der oberen Hälfte der Schaltungsanordnung in die untere Hälfte der Schaltungsanordnung zeitlich versetzt eingekoppelt werden. Die beiden Abtastschaltsignale sample_p, sample_n sind zeitlich versetzt zueinander um den zeitlichen Versatz dt_pn. Eine Verlängerung der Flanken führt zu einer Flanke des Verstärkungssignals amplify, was dem mittleren Signalverlauf in Fig. 4b entnehmbar ist. Darunter dargestellt sind das Vergleichsschaltungssignal compare und das Verzögerungssignal latch, welche abhängig vom zeitlichen Versatz dt_pn in Verbindung mit der ansteigenden Flanke des Verstärkungssignals amplify angesteuert werden.

Die Verzögerungsmodule werden vorzugsweise einstellbar ausgelegt, z.B. mit 3 Bit. Ein typischer Einstellbereich für den zeitlichen Versatz *dt_pn* liegt bei vielen Applikationen innerhalb 5-40% der Abtastperiode. Eine platzsparende Realisierung dafür sieht folgendermaßen aus: die Verzögerungsschaltungen 8 setzen sich vorzugsweise aus einem Eingangstreiber, z.B. einem Inverter, einem variablen RC-Glied, einem Schmitttrigger und ggf. einem Ausgangstreiber zusammen. Die Einstellung der Verzögerung geschieht über mehrere in Serie geschaltete, z.B. binär gestufte Widerstände, die jeweils über parallelgeschaltete npmos-Transmissiongates, insbesondere mit symmetrischer npmos-Leitwertcharakteristik über der Kanalspannung, einzeln zu- oder abgeschaltet werden. Die Kapazität des RC-Gliedes kann über zwei Gateoxidkapazitäten realisiert werden, welche bevorzugt mit einer Basisspannung oder einer Versorgungsspannung verbunden sind.

Der Vergleich mit der Referenz geschieht in der kompakten Implementierung von Fig. 5 über asymmetrisch dimensionierte Inverter. Dargestellt sind der erste und der zweite Signaleingang für die Eingangssignale sigp, sign, welche auf die jeweils zwei Verstärkereingänge zweier Verstärker 1° mittels Schalteinrichtungen sl_p, s2_p, s1_n, s2_n schaltbar sind. Der jeweils negative Ausgang der beiden Vertärker 1° ist jeweils einer Inverterschaltung 11 über zwischengeschaltete Kondensatoren zugeführt. Die Inverterschaltungen bestehen aus jeweils einem ersten Inverter Inv_m, welcher über einen weiteren Schalter s_o wieder auf den Eingangspunkt des ersten Inverters Inv_m zurückgeführt ist. Dieser Eingangspunkt ist außerdem an Eingänge eines zweiten und dritten Inverters Inv_h, Inv_l geschaltet, deren Ausgänge den vier Eingängen des Kodierers 4 angelegt sind.

Mittels einer solchen Schaltungsanordnung bzw. Schaltmatrix wird die Krümmung curvature als Ausgangssignal des Kodierers 4 bestimmt, wobei die in Fig. 5b angegebenen Signalverläufe den Signalen an den entsprechend bezeichneten Schaltern, dem Verstärkungssignal amplify der Verstärker 1° bzw. dem Verzögerungssignal latch entsprechen. Dargestellt sind außerdem der zeitliche Versatz dt_pn zwischen den Signalzuständen der beiden Schaltsignale der oberen Hälfte der Schaltungsanordnung als zeitlicher Versatz dt_pn und außerdem der zeitliche weitere Versatz dt_grad zwischen den entsprechenden Schaltsignalen der oberen Hälfte der Schaltungsanordnung und der unteren Hälfte der Schaltungsanordnung.

Dabei wird während einer Offsetphase die Differenz zwischen dem Arbeitspunkt des Verstärkerausgangs eines Verstärkers 1° und einem Schaltpunkt *Vs_inv_m* eines symmetrisch ausgelegten ersten Inverters Inv_m in der Kapazität Coffset (Bez. fehlt in fig.5a) gespeichert. Die bezüglich des ersten Inverters Inv_m asymmetrisch dimensionierten zweiten und dritten Inverter Inv_h und Inv_l besitzen zweite und dritte Inverter-Schaltpunkte Vs_inv_h und Vs_inv_l, die jeweils über und unterhalb der Schaltschwelle des ersten Inverters Inv_m liegen. Die Schaltschwellen dieser beiden zweiten und dritten Inverter Inv_h und Inv_1 sind vorzugsweise einstellbar, beispielsweise durch Deaktivieren/Aktivieren parallelgeschalteter Transistoren. In der Verstaerkungsphase (amplify = 1) wird der Schalter *s_o* geöffnet und je nach Aussteuerung der Verstärkerstufen mit den Verstärkern 1° ergibt sich durch die als Komparatoren fungierenden Inverter beispielsweise folgende Schaltmatrix :

```
dV_grad*amp  >  2*(Vs_inv_h - Vs_inv_m)
   ➔  (Inv_h_o, Inv_l_o) = 11
2*(Vs_inv_h - Vs_inv_m) >= dV_grad*amp >= 2*(Vs_inv_l -
 Vs_inv_m)   ➔   ( Inv_h_o, Inv_l_o ) = 01


2*( Vs_inv_l - Vs_inv_m )  >  dV_grad * amp
   ➔ ( Inv_h_o, Inv_l_o ) = 00
```

Eine entsprechende Schaltmatrix ergibt sich für den zweiten Gradienten. Die beiden 2 Bit-Resultate (Inv_h1_o, Inv_l1_o) und (Inv_h2_o, Inv_l2_o) lassen sich beispielhaft in einer Weise kodieren, so dass sich ein Maß für die Signalsteilheit und die Änderung derselbigen als insbesondere Krümmung curvature ergibt:

```
grad1    <=   Inv_h1_o  XNOR  Inv_l1_o;


grad2    <=   Inv_h2_o  XNOR  Inv_l2_o;


curvature <=   [ grad1, grad2 ];
```

In diesem Beispiel wird die Information über die Vorzeichen der Gradienten nicht weiter verwertet, lediglich die Betragswerte der Gradienten wirken sich aus. Damit ergibt sich für die Krümmung *curvature* bei der Abtastung einer Übergangsphase zwischen zwei Pegeln für eine ansteigende Flanke, wie aus Fig. 7 ersichtlich ist:

eingeschwungen 00,
konkav ansteigend 01,

linear steigend 11,
konvex abflachend 10,
eingeschwungen 00

und für eine abfallende Flanke
eingeschwungen 00,
konvex abfallend 01,
linear fallend 11,
konkav abflachend 10,
eingeschwungen 00.

Dargestellt ist in Fig. 7 eine Signalspannung V-signal über der Zeit t für die Eingangssignale sigp, sign im Bereich von den Übergangsflanken. Veranschaulicht sind dabei die verschiedenen Größen, welche für das Verfahren bzw. die Vorrichtungsanordnung von Bedeutung sind. Neben dem Abtasttakt t_abtast ist auch ein zeitlicher Mittelwert t_mid zwischen den einzelnen differenziellen Größen dargestellt. Als differenzielle Größe sind die beiden zeitlichen Versätze dt_grad, dt_pn und die Differenz dv_grad der Spannung des Gradienten skizziert. Fig. 7b zeigt die Signalspannung V_signal über dem zeitlichen Mittelwert t_mid, wobei wieder die beiden entsprechenden Eingangssignalkurven skizziert sind. Zentral befindet sich ein dynamischer Bereich, welcher die Krümmungswerte 11 zugewiesen bekommt, wie dies auch anhand der vorstehenden Auflistung in Art einer Tabelle entnehmbar ist.

Der Grund für diese Kodierung wird aus der Beschreibung des Regelverfahrens ersichtlich.

Die Gradientenmessung erfolgt insbesondere bei kurzen Verzögerungszeiten bzw. sehr hohen Pixelfrequenzen vorzugsweise nach dem hold&amplify-Verfahren, da sich hier die Verzögerung der Verstärkerstufe nicht negativ auf die Gradientenermittlung auswirkt. Außerdem stören sich bei einem differentiellen Signalpfad die beiden Messprozesse für zwei aufeinanderfolgende Gradienten gegenseitig weniger, wenn sie nicht beide differentiell, sondern jeweils single-ended erfolgen.

Im Weiteren wird ein Regelverfahren exemplarisch beschrieben, das mit der obigen Kodierung arbeitet. Dabei sind typischerweise die Flanken folgender Takte von Bedeutung, wie dies aus Fig. 1 ersichtlich ist:

Die Signal- oder Pixelfrequenz ist eine Frequenz, mit der sich ggf. die Signalpegel ändern, der Messtakt ist eine Frequenz, in der sich die Gradientenmessung wiederholt, der Abtasttakt ist ein Takt zur Signalverarbeitung mit konstantem Versatz zum Messtakt und a priori unbekanntem Versatz zum Pixeltakt und der PLL-Takt gibt ggf. die Schrittweite der insbesondere digitalen Phasenregelung vor.

Das erfindungsgemäße Regelverfahren beinhaltet folgende Prozessschritte:

Anfangs befindet sich die Regelung im Suchmodus. Der Messtakt wird, beispielsweise in Zeitschritten der halben PLL-Periode, in regelungsspezifischen Zeitabständen in eine bestimmte Richtung verschoben, bis, etwa mittels der erfindungsgemäßen Sensoren, ein Gradient detektiert wird. Daraufhin wird der Messtakt bezüglich der Sensorwerte in den Bereich maximaler Signaldynamik geregelt, was einer Krümmung → curvature = 11 entspricht, d.h. der durchschnittliche Wert von der Krümmung *curvature* wird maximiert. Befindet sich der Messzeitpunkt mitten im Übergangsbereich mit einer Krümmung curvature = 11, so besteht kein weiterer Änderungsbedarf für die Phase.

Driftet nun die Pixelsequenz relativ zum Messtakt, so wird sich mit der Zeit die Krümmung curvature von 11 nach 10 oder 01 ändern. Für die Phasennachregelung wird nun z.B. bei einer digitalen Taktregelung folgendermaßen verfahren:

Überschreitet die Summe der 10-Ereignisse innerhalb einer bestimmten, vorzugsweise einstellbaren Anzahl von Messtakten einen vorgegebenen, vorzugsweise einstellbaren Schwellwert, so wird der Messtakt einmalig verkürzt und damit relativ zum Signalverlauf nach links verschoben. Der Abtasttakt hat vorzugsweise einen konstanten Phasenversatz zum Messtakt, der je nach Applikation einstellbar ist und folgt somit dieser Verschiebung. Überschreitet in Analogie dazu die Summe der (01)-Ereignisse innerhalb einer bestimmten Zeit einen vorgegebenen Schwellwert, so wird der Messtakt einmalig verlängert und damit relativ zum Signalverlauf nach rechts verschoben. Überschreiten sowohl die (01)- als auch die (10)-Ereignisse ihre Schwellwerte, so wird die Phase gemäß dem häufiger auftretenden Ereignis verschoben. Der Betrag der Phasenverschiebung kann variabel sein und z.B. von dem Verhältnis von (11) zu (01/10)-Ereignissen abhängen und er wird ggf. durch die PLL-Frequenz vorgegeben.

Falls ein stetiger Regelbedarf in jeweils eine Richtung auftritt, kann bei Überschreitung eines vorzugsweise einstellbaren Schwellwertes die Frequenz des Mess- und des Abtasttaktes dauerhaft angepasst werden. Werden dagegen kurzfristige Frequenzschwankungen nachgeregelt, kann dies typischerweise über einmalige Phasenverschiebungen geschehen.

Ergibt sich eine Krümmung curvature = 00, so hat das Signal entweder keine hinreichend große Pegeländerung vollzogen oder die Messungen wurden im eingeschwungenen Bereich durchgeführt. In beiden Fällen kann über die optimale Phasenlage keine Aussage gemacht werden und es wird keine Phasenänderung vorgenommen. Wird für eine bestimmte, vorzugsweise einstellbare Zeitdauer kein Gradient detektiert, kann die Regelschaltung wieder in den Suchmodus versetzt werden.

Der Abtasttakt hat vorzugsweise einen konstanten Phasenversatz *dPhi* zum Messtakt, der je nach Applikation einstellbar ist und wird somit zusammen mit dem Messtakt relativ zum Pixeltakt verschoben. Typischerweise beträgt der Phasenversatz 40-90% der Taktperiode, so dass gewährleistet wird, dass die Abtastung in der eingeschwungenen Phase stattfindet und durch den Messvorgang nicht gestört wird. Mit einem einstellbaren Phasenversatz kann auch die Phasenverschiebung des Messpfades berücksichtigt werden.

Möglich sind auch andere Realisierungsmöglichkeiten des erfindungsgemäßen Konzepts.

In vorherigen Abschnitt wurden zwei Sensorausführungen für die differentielle und single-ended Gradientenmessung beschrieben. In Fig. 6 sind zwei Anordnungen zur Erfassung und Verarbeitung mehrerer Gradientenmessungen exemplarisch skizziert. Es handelt sich um eine Anordnung mit differentiell- und eine mit single-ended gespeisten Sensoren. Im Allgemeinen sind auch geeignete Kombinationen dieser Anordnungen möglich. In der oberen Schaltungsanordnung sind dabei zwei differenzielle Elemente 20, 21 zwischen die beiden Signaleingänge zum Anlegen der Eingangssignale sigp, sign geschaltet, welche von einem Taktgenerator 23 mit einem Taktsignal angesteuert werden. Das Taktsignal wird zwischen den Takteingängen der beiden differenziellen Elemente 20, 21 um den zeitlichen Versatz dt_pn mittels eines entsprechenden Verzögerungselements 24 verzögert. Jeweils zwei Ausgänge der differenzierenden Elemente 20, 21 sind einem Kodierer 4* angelegt, dessen Ausgänge am Taktgenerator 23 anliegen. Das Taktsignal des Taktgenerators 23 wird außerdem um einen konstanten Phasenversatz dPhi mittels eines weiteren Verzögerungselements 25 (Bez. Fehlt in fig.6) verzögert und dem AD-Wandler 2 angelegt. Diesem liegen auch die beiden Eingangssignale sigp, sign an entsprechenden Eingängen an. Der Verlauf der beiden Eingangssignale sigp, sign ist in dem über die Zeit t dargestellten Verlauf der Signalspannung V_signal dargestellt. Skizziert sind dabei insbesondere auch die beiden zeitlichen Versätze dt_pn, dt_grad.

In der darunter dargestellten Schaltungsanordnung sind an Stelle der differenziellen Elemente 20, 21 Elemente 20*, 21* zur single-ended-Gradientenmessung abgebildet. Rechts davon ist wiederum der Verlauf der Signalspannung V_Signal über der Zeit für die beiden Eingangssignale dargestellt, welche zeitlich abwechselnd aktiv sind.

Das sample&track Prinzip kann auch bei single-ended Signalen verwendet werden.

Ein weiteres Regelverfahren kann darin bestehen, dass der Messtakt aus dem Dynamikbereich heraus in einen eingeschwungenen Bereich hineingeregelt wird. Dies hätte aber ggf. den Nachteil, dass die Regelung bezüglich der Phasendrift einen "blinden Winkel" aufweist und eine Korrektur gegebenenfalls zu spät erfolgen würde.

Das erfindungsgemäße Regelverfahren funktioniert auch mit einer analogen Taktregelschleife. Dabei werden keine einmaligen Variationen der Taktperiode zur Phasenschiebung vorgenommen, sondern es erfolgt eine kontinuierliche Taktanpassung. Diese kontinuierliche Feinjustierung hat gegenüber einer digitalen Taktrekonstruktion den Vorteil, dass es zu keiner abrupten Änderung der Abtastflanken kommt. Letzteres führt ähnlich wie ein starker Taktjitter zu einer Verzerrung der Abtastwerte.

Möglichen Anwendungen finden sich in verschiedenen Schaltungen, z.B. als Sensor für die Gradientenmessung in analogen Signalverläufen. Solche Sensoren werden beispielsweise für die Phaseneinstellung zur optimalen Verarbeitung einer zeitdiskreten Signalfolge benötigt, etwa um diese während der eingeschwungenen Phasen abzutasten. Die Sensorergebnisse können außerdem zur Rekonstruktion abgetasteter Signalsequenzen dienen.

Die erfindungsgemäßen Schaltungen können auch zur Detektion und Ausregelung von Frequenzschwankungen bzw. von Phasendrift ggf. in Verbindung mit dem angegebenen Regelalgorithmus verwendet werden. Eine schnelle Nachregelung ist insbesondere bei Hochgeschwindigkeitsschnittstellen sehr vorteilhaft, da hier das Verhältnis von Phasenschwankung zu Signalperiode kritisch wird.

Weitere Vorteile der vorliegenden Erfindung bestehen neben den bereits erläuterten Vorteilen.

Es kommt zu keiner Störung des Signalpfades, falls die Messung in ausreichendem zeitlichen Abstand zur Abtastung stattfindet. Wird die Gradientenmessung auf die Übergangsphase eingeregelt, so kann die Abtastung im Signalpfad mit geeignetem Phasenversatz erfolgen. Dieser ist vorzugsweise applikationsspezifisch einstellbar.

Fig. 7 zeigt Signalspannungen V_signal für die beiden Eingangssignale sigp, sign (Fig. 7a) bzw. die bestimmten Krümmungswerte (Fig. 7b). Dargestellt sind neben einzelnen der beschriebenen Versatzwerte und sonstigen Größen einschließlich Schaltgrößen die entsprechenden Kurven für eine Gradientenmessung und Sensorwerte in Abhängigkeit von der Phase. Zusammenfassend betrifft die Erfindung eine Vorrichtung zur Gradientenermittlung, die dazu ausgebildet ist, die Änderung eines Signalpegels zwischen zwei Zeitpunkten mit Referenzwerten zu vergleichen und abhängig von dem Vergleich ein Maß für den Signalgradienten zu ermitteln. Diese Vorrichtung dient der Signalrekonstruktion, wobei beispielsweise die Phase des Signalverarbeitungstaktes relativ zum Gradientenmesstakt eingestellt oder ein Maß für Signalwerte zwischen mehreren Abtastpunkten ermittelt werden kann.

Die Erfindung betrifft außerdem ein Verfahren zur Regelung von Signalverläufen basierend auf Gradientenwerten, bei dem aus der unmittelbaren zeitlichen Abfolge mehrerer Gradienten ein Maß für den Gradientenverlauf bzw. die Krümmung des Signals ermittelt wird. Durch eine sequentielle Auswertung dieser Maße kann die Richtung der Phasendrift des Signals bestimmt und beispielsweise zur Synchronisierung oder Phasenregelung herangezogen werden.

**Patentansprüche**

1. Verfahren zur Gradientenermittlung, bei dem eine Änderung eines Signalpegels eines Eingangssignals (sigp, sign) zwischen zwei Zeitpunkten bestimmt und mit Referenzwerten (refl, refh) verglichen wird, wobei abhängig vom Vergleich ein Maß für den Gradienten des Eingangssignals ermittelt wird.

2. Verfahren nach Anspruch 1, bei dem eine Phase eines Taktes (dPhi) für eine Signalverarbeitung relativ zu einem Messtakt eingestellt wird.

3. Verfahren nach Anspruch 1 oder 2, bei dem aus der zeitlichen Abfolge mehrerer Gradienten ein Maß für den Gradientenverlauf und/oder eine Krümmung (curvature) des Eingangssignals (sigp, sign) ermittelt wird.

4. Verfahren nach Anspruch 3, bei dem als die Abfolge eine unmittelbare zeitliche Abfolge mehrerer Gradienten verwendet wird.

5. Verfahren nach Anspruch 3 oder 4, bei dem aus einer sequenziellen Auswertung von Werten der Krümmung eine Richtung der Phasendrift des Eingangssignals bestimmt und zur Regelung einer Phase eines Taktes für eine Signalverarbeitung verwendet wird.

6. Verfahren nach einem der Ansprüche 3 bis 5, bei dem eine exakte Anzahl von Signalperioden zwischen zwei Synchronisationssignalen nicht bekannt ist und/oder eine Übertragungsrate zeitlich schwankt.

7. Verfahren nach einem vorstehenden Anspruch, bei dem Signalverläufe auf Basis von Werten des ermittelten Gradienten des Eingangssignals (sigp, sign) geregelt werden.

8. Verfahren nach einem vorstehenden Anspruch zur Regelung von Signalverläufen basierend auf Gradientenwerten, bei dem aus der unmittelbaren zeitlichen Abfolge mehrerer Gradienten das Maß für den Gradientenverlauf bzw. die Krümmung des Signals ermittelt wird.

9. Vorrichtung zur Gradientenermittlung, die dazu ausgebildet ist, die Änderung eines Signalpegels eines Eingangssignals (sigp, sign) zwischen zwei Zeitpunkten mit Referenzwerten zu vergleichen und abhängig von dem Vergleich ein Maß für den Signalgradienten zu ermitteln.

10. Vorrichtung nach Anspruch 9 mit einer sample&track-Stufe (1) und einer dieser nachgeschalteten Vergleichsschaltung zum Vergleichen der Änderung des Signalpegels mit den Referenzwerten.

11. Vorrichtung nach Anspruch 9 oder 10 mit einer sample&hold-Stufe (5) und einer dieser nachgeschalteten Vergleichsschaltung zum Vergleichen der Änderung des Signalpegels mit den Referenzwerten.

12. Vorrichtung nach einem der Ansprüche 9 bis 11 mit einer Stufe (20, 21; 20*, 21*) zur differenziellen und/oder Single-Ended-Gradientenmessung.

13. Vorrichtung nach einem der Ansprüche 9 bis 12 mit einer Ausgestaltung zum Durchführen eines Verfahrens nach einem der Ansprüche 1 bis 8.

Fig. 1

Fig. 2

Fig. 3

Fig. 5

(4a)

(4b)

Fig. 4

(7a)          (7b)

Fig. 7

Fig. 6

Europäisches
Patentamt

**Nummer der Anmeldung**

EP 06 01 1435

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| P,D, Y | DE 10 2004 027093 A1 (MICRONAS GMBH) 29. Dezember 2005 (2005-12-29) * Zusammenfassung * ----- | 1-13 | INV. H04N5/12 |
| X | US 5 576 904 A (BEHRENS ET AL) 19. November 1996 (1996-11-19) | 1,2,9 | |
| Y | * Spalte 9, Zeile 8 - Zeile 25 * | 3-8, 10-13 | |
| Y | US 6 473 131 B1 (NEUGEBAUER CHARLES F ET AL) 29. Oktober 2002 (2002-10-29) * Spalte 6, Zeile 50 - Zeile 63 * ----- | 1-13 | |
| Y | US 5 475 718 A (ROSENKRANZ ET AL) 12. Dezember 1995 (1995-12-12) * Spalte 9, Zeile 55 - Zeile 60 * ----- | 1-13 | |
| A | EP 0 749 236 A (SEIKO EPSON CORPORATION) 18. Dezember 1996 (1996-12-18) * Abbildungen 1a,1b * ----- | 1-13 | |
| A | US 5 266 850 A (AU ET AL) 30. November 1993 (1993-11-30) * Spalte 1, Zeile 45 - Zeile 51; Tabelle 1 * ----- | 1-13 | RECHERCHIERTE SACHGEBIETE (IPC) H04N H03K H03L |
| A | US 2002/017934 A1 (SHOJI NORIO ET AL) 14. Februar 2002 (2002-02-14) * Abbildung 4 * ----- | 1-13 | |
| A | US 6 229 862 B1 (WEBB WILLIAM TIMOTHY) 8. Mai 2001 (2001-05-08) * Spalte 3 - Spalte 4 * ----- | 1-13 | |
| A | US 2001/055355 A1 (OKAMOTO KOJI) 27. Dezember 2001 (2001-12-27) * Absätze [0004], [0029] * ----- | 1-13 | |

Der vorliegende Recherchenbericht wurde für alle Patentansprüche erstellt

| Recherchenort | Abschlußdatum der Recherche | Prüfer |
|---|---|---|
| München | 28. Juli 2006 | Müller, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................

& : Mitglied der gleichen Patentfamilie, übereinstimmendes Dokument

EPO FORM 1503 03.82 (P04C03)

**EP 1 732 309 A1**

ANHANG ZUM EUROPÄISCHEN RECHERCHENBERICHT
ÜBER DIE EUROPÄISCHE PATENTANMELDUNG NR.                EP 06 01 1435

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-07-2006

| Im Recherchenbericht angeführtes Patentdokument | Datum der Veröffentlichung | Mitglied(er) der Patentfamilie | Datum der Veröffentlichung |
|---|---|---|---|
| DE 102004027093 A1 | 29-12-2005 | EP 1603330 A2<br>US 2006023120 A1 | 07-12-2005<br>02-02-2006 |
| US 5576904 A | 19-11-1996 | DE 69519740 D1<br>DE 69519740 T2<br>EP 0784849 A2<br>JP 10508135 T<br>WO 9610254 A2<br>US 5642243 A<br>US 5754352 A | 01-02-2001<br>12-07-2001<br>23-07-1997<br>04-08-1998<br>04-04-1996<br>24-06-1997<br>19-05-1998 |
| US 6473131 B1 | 29-10-2002 | KEINE | |
| US 5475718 A | 12-12-1995 | DE 4303356 A1<br>EP 0610990 A2<br>JP 3605132 B2<br>JP 7095055 A | 11-08-1994<br>17-08-1994<br>22-12-2004<br>07-04-1995 |
| EP 0749236 A | 18-12-1996 | DE 69615755 D1<br>DE 69615755 T2<br>JP 3622270 B2<br>JP 9006307 A<br>US 5936678 A | 15-11-2001<br>20-06-2002<br>23-02-2005<br>10-01-1997<br>10-08-1999 |
| US 5266850 A | 30-11-1993 | KEINE | |
| US 2002017934 A1 | 14-02-2002 | JP 2001332034 A | 30-11-2001 |
| US 6229862 B1 | 08-05-2001 | AU 652068 B2<br>AU 2197792 A<br>CA 2112595 A1<br>DE 69230337 D1<br>DE 69230337 T2<br>EP 0592615 A1<br>FI 935967 A<br>WO 9301667 A1<br>JP 6508969 T | 11-08-1994<br>11-02-1993<br>21-01-1993<br>30-12-1999<br>08-06-2000<br>20-04-1994<br>31-12-1993<br>21-01-1993<br>06-10-1994 |
| US 2001055355 A1 | 27-12-2001 | JP 2002008322 A | 11-01-2002 |

Für nähere Einzelheiten zu diesem Anhang : siehe Amtsblatt des Europäischen Patentamts, Nr.12/82

15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004027093